# EUROPÄISCHE PATENTSCHRIFT

(11) **EP 2 130 053 B1**
(45) Veröffentlichungstag und Bekanntmachung des Hinweises auf die Patenterteilung: **09.06.2010**
(21) Anmeldenummer: 08717660.8
(22) Anmeldetag: 12.03.2008
(51) Int. Cl.: G01R 19/00, F02D 41/22

(54) **VERFAHREN ZUM ERFASSEN EINER ELEKTRISCHEN POTENTIALDIFFERENZ AN EINER PIEZOELEKTRISCHEN AKTOREINHEIT UND SCHALTUNGSANORDNUNG ZUR DURCHFÜHRUNG DES VERFAHRENS**
METHOD FOR DETECTING AN ELECTRIC POTENTIAL DIFFERENCE ON A PIEZOELECTRIC ACTUATOR UNIT AND CIRCUIT ARRANGEMENT FOR CARRYING OUT SAID METHOD
PROCÉDÉ DE DÉTECTION D'UNE DIFFÉRENCE DE POTENTIEL ÉLECTRIQUE SUR UNE UNITÉ D'ACTIONNEUR PIÉZOÉLECTRIQUE ET CIRCUITERIE DESTINÉE À LA MISE EN OEUVRE DU PROCÉDÉ

(30) Priorität: 26.03.2007 DE 102007014329
(43) Veröffentlichungstag der Anmeldung: 09.12.2009
(73) Patentinhaber: Robert Bosch GmbH, 70442 Stuttgart (DE)
(72) Erfinder: FUCHS, Stefan, 70469 Stuttgart (Feuerbach) (DE); GRAF, Marco, 71254 Ditzingen (DE)
(86) Internationale Anmeldenummer: PCT/EP2008/052914
(87) Internationale Veröffentlichungsnummer: WO 2008/116750

(56) Entgegenhaltungen:
- DE-A1-102004 037 720
- US-A1- 2005 231 212

## Beschreibung

Die vorliegende Erfindung betrifft eine Schaltungsanordnung zum Betreiben eines piezoelektrischen Elements, und betrifft insbesondere eine Schaltungsanordnung und ein Verfahren zum Überwachen des piezoelektrischen Elements. Spezifisch betrifft die vorliegende Erfindung eine Schaltungsanordnung zur Erfassung einer zeitlich veränderlichen Amplitude mindestens einer zu erfassenden elektrischen Potentialdifferenz mit einer ersten Potentialdifferenz-Erfassungseinrichtung zur Erfassung der mindestens einen elektrischen Potentialdifferenz und zur Ausgabe eines ersten Potentialdifferenzsignals, und einer zweiten Potentialdifferenz-Erfassungseinrichtung zur Erfassung der mindestens einen elektrischen Potentialdifferenz und zur Ausgabe eines zweiten Potentialdifferenzsignals.

Ansteuervorrichtungen für piezoelektrische Elemente werden z.B. in Kraftstoffeinspritzeinlagen eines Kraftfahrzeugs eingesetzt. Derartige piezoelektrische Elemente dienen hierbei als ein Stellglied, das mit einem Steuerstrom beaufschlagbar ist. Zur Steuerung eines derartigen Stellglieds muss die an dem Stellglied anliegende Spannung mit hoher Präzision überwacht werden.

### STAND DER TECHNIK

Die Funktionsfähigkeit von Einspritzsystemen für Brennkraftmaschinen beruht auf einer exakten Ansteuerung der als Piezoaktoren ausgebildeten Stellglieder für eine Kraftstoffeinspritzung. In der DE 10 2004 037 720 A1 ist eine Ansteuerschaltung für ein Stellglied beschrieben, wobei piezoelektrische Elemente angesteuert werden, welche beispielsweise eine Ventilnadel eines Einspritzventils bewegen, um eine Kraftstoffeinspritzung in einen Brennraum der Brennkraftmaschine zu bewirken.

Die in der DE 10 2004 037 720 A1 beschriebene Ansteuerschaltung ist derart ausgelegt, dass Störströme, die beispielsweise durch Zuleitungsinduktivitäten der piezoelektrischen Elemente bei vorgegebenen Stromverläufen auftreten, weitestgehend vermieden werden.

In der DE 10 2004 058 671 A1 ist eine weitere elektrische Schaltung zur Ansteuerung eines piezoelektrischen Elements insbesondere einer Kraftstoffeinspritzanlage eines Kraftfahrzeugs offenbart. Hierbei sind zwei in Serie geschaltete, mit einem Takt ansteuerbare Transistoren bereitgestellt, deren gemeinsamer Anschlusspunkt mit dem piezoelektrischen Element gekoppelt ist, und von welchen einer zur Entladung des piezoelektrischen Elements vorgesehen ist. Zwar kann in einem Fehlerfall eine schnelle Entladung des piezoelektrischen Elements sichergestellt werden, in nachteiliger Weise ist es mit der beschriebenen Anordnung jedoch nicht möglich, eine Spannung an dem piezoelektrischen Element zuverlässig und massepotentialfrei zu überwachen.

Um mit einem piezoelektrischen Element Kraftstoff in einen Brennraum einbringen zu können, muss das piezoelektrische Element auf eine Spannung von bis zu 200 V aufgeladen werden. Ein Aufladen/Entladen des piezoelektrischen Elements (der Aktoreinheit) erfolgt mit einem gepulsten Strom. Übliche Common-Rail-Piezodieselsysteme weisen einen Pol des piezoelektrischen Elements verbunden mit dem Massepotential auf. Somit kann zum Messen der Aktorspannung Potential an dem anderen Ende des piezoelektrischen Elements erfasst und gegen Masse bestimmt werden.

Bei der Weiterentwicklung piezoelektrischer Elemente zur hochpräzisen Kraftstoffeinspritzung ist jedoch keiner der Anschlüsse des piezoelektrischen Elements mit Masse verbunden. Vielmehr ist das piezoelektrische Element nicht nur auf eine positive Spannung, sondern auch auf eine leicht negative Spannung aufladbar. Hierzu wird ein Pol des piezoelektrischen Elements (Niedrigspannungsseite) auf eine Spannung von ca. 45 V gegenüber Masse gelegt. Problematisch ist es, wenn ein Anschluss auf der Hochspannungsseite ebenfalls ein derartiges Potential kleiner 45 V angelegt wird, da dann die Differenzspannung am Aktor negativ wird. Um derartige piezoelektrische Elemente einsetzen und überwachen zu können, muss eine massepotentialfreie Differenzspannungsmessung vorgesehen werden.

### VORTEILE DER ERFINDUNG

Die der vorliegenden Erfindung zugrundeliegende Problematik besteht daher darin, eine zuverlässige, in der Zeit und in der Amplitude hochaufgelöste Differenzspannungsmessung an einem piezoelektrischen Stellglied vorzusehen.

Zur Lösung wird erfindungsgemäß eine Schaltungsanordnung zur Erfassung einer zeitlich veränderlichen Amplitude mindestens einer zu erfassenden elektrischen Potentialdifferenz mit den Merkmalen des Patentanspruchs 1 vorgeschlagen. Ferner wird ein Verfahren zum Erfassen einer zeitlich veränderlichen Amplitude mindestens einer zu erfassenden elektrischen Potentialdifferenz angegeben, welches die in dem nebengeordneten Anspruch 6 enthaltenen Schritte aufweist. Weitere Ausgestaltungen der Erfindung ergeben sich aus den Unteransprüchen.

Ein wesentlicher Gedanke der Erfindung besteht darin, zwei unterschiedliche Potentialdifferenz-Erfassungseinrichtungen zur Erfassung der mindestens einen elektrischen Potentialdifferenz und zur Ausgabe von Potentialdifferenzsignalen vorzusehen, wobei eine erste Potentialdifferenz-Erfassungseinrichtung eine höhere Zeitauflösung als eine zweite Potentialdifferenz-Erfassungseinrichtung aufweist, und wobei die zweite Potentialdifferenz-Erfassungseinrichtung eine höhere Amplitudenauflösung als die erste Potentialdifferenz-Erfassungseinrichtung aufweist.

Mit einer derartigen Differenzspannungs-Überwachungseinrichtung können piezoelektrische Elemente, die beispielsweise in Piezo-Common-Rail-Dieselsystemen mit Injektor mit direkter Nadelsteuerung eingesetzt werden, in zuverlässiger Weise überwacht werden. In vorteilhafter Weise stellt eine Verarbeitungseinrichtung eine Verarbeitung der ersten und zweiten Potentialdifferenzsignale derart bereit, dass ein Steuersignal gewonnen wird, welches eine hohe Amplitudenauflösung und/oder eine hohe Zeitauflösung aufweist.

Ein wesentlicher Gedanke der vorliegenden Erfindung besteht darin, dass die erste Potentialdifferenz-Erfassungseinrichtung derart ausgelegt ist, dass diese das erste Potentialdifferenzsignal analog bestimmt, während mindestens eine zweite Potentialdifferenz-Erfassungseinrichtung derart ausgelegt ist, das zweite Potentialdifferenzsignal digital zu bestimmen.

Gemäß einem allgemeinen Aspekt weist die erfindungsgemäße Schaltungsanordnung zur Erfassung einer zeitlich veränderlichen Amplitude mindestens einer zu erfassenden elektrischen Potentialdifferenz im Wesentlichen auf:
a) eine erste Potentialdifferenz-Erfassungseinrichtung zur Erfassung der mindestens einen elektrischen Potentialdifferenz und zur Ausgabe eines ersten Potentialdifferenzsignals; und
b) mindestens eine zweite Potentialdifferenz-Erfassungseinrichtung zur Erfassung der mindestens einen elektrischen Potentialdifferenz und zur Ausgabe eines zweiten Potentialdifferenzsignals, wobei die erste Potentialdifferenz-Erfassungseinrichtung eine höhere Zeitauflösung als die zweite Potentialdifferenz-Erfassungseinrichtung aufweist, und die zweite Potentialdifferenz-Erfassungseinrichtung eine höhere Amplitudenauflösung als die erste Potentialdifferenz-Erfassungseinrichtung aufweist.

Ferner weist das erfindungsgemäße Verfahren zum Erfassen einer zeitlich veränderlichen Amplitude mindestens einer zu erfassenden elektrischen Potentialdifferenz im Wesentlichen die folgenden Schritte auf:
a) Erfassen der mindestens einen elektrischen Potentialdifferenz mittels einer ersten Potentialdifferenz-Erfassungseinrichtung;
b) Ausgeben eines ersten Potentialdifferenzsignals aus der ersten Potentialdifferenz-Erfassungseinrichtung;
c) Erfassen der mindestens einen elektrischen Potentialdifferenz mittels einer zweiten Potentialdifferenz-Erfassungseinrichtung; und
d) Ausgeben eines zweiten Potentialdifferenzsignals aus der zweiten Potentialdifferenz-Erfassungseinrichtung, wobei die erste Potentialdifferenz-Erfassungseinrichtung die elektrische Potentialdifferenz mit einer höheren Zeitauflösung erfasst als die zweite Potentialdifferenz-Erfassungseinrichtung, und die zweite Potentialdifferenz-Erfassungseinrichtung die elektrische Potentialdifferenz mit einer höheren Amplitudenauflösung erfasst als die erste Potentialdifferenz-Erfassungseinrichtung.

In den Unteransprüchen finden sich vorteilhafte Weiterbildungen und Verbesserungen des jeweiligen Gegenstandes der Erfindung.

Gemäß einer bevorzugten Weiterbildung der vorliegenden Erfindung ist die erste Potentialdifferenz-Erfassungseinrichtung derart ausgelegt, dass das erste Potentialdifferenzsignal analog bestimmt wird.

Gemäß noch einer weiteren bevorzugten Weiterbildung der vorliegenden Erfindung ist die zweite Potentialdifferenz-Erfassungseinrichtung derart ausgelegt, dass das zweite Potentialdifferenzsignal digital bestimmt wird.

Vorzugsweise ist der ersten Potentialdifferenz-Erfassungseinrichtung ein Analog-Digital-Konverter nachgeschaltet.

Gemäß noch einer weiteren bevorzugten Weiterbildung der vorliegenden Erfindung ist eine Verarbeitungseinrichtung zur Verarbeitung des ersten Potentialdifferenzsignals und des zweiten Potentialdifferenzsignals bereitgestellt, wobei die Verarbeitungseinrichtung ein Steuersignal ausgibt, welches eine hohe Amplitudenauflösung und/oder eine hohe Zeitauflösung aufweist.

### ZEICHNUNG

Ein Ausführungsbeispiel der Erfindung ist in der Zeichnung dargestellt und in der nachfolgenden Beschreibung näher erläutert.

In der Zeichnung zeigt:

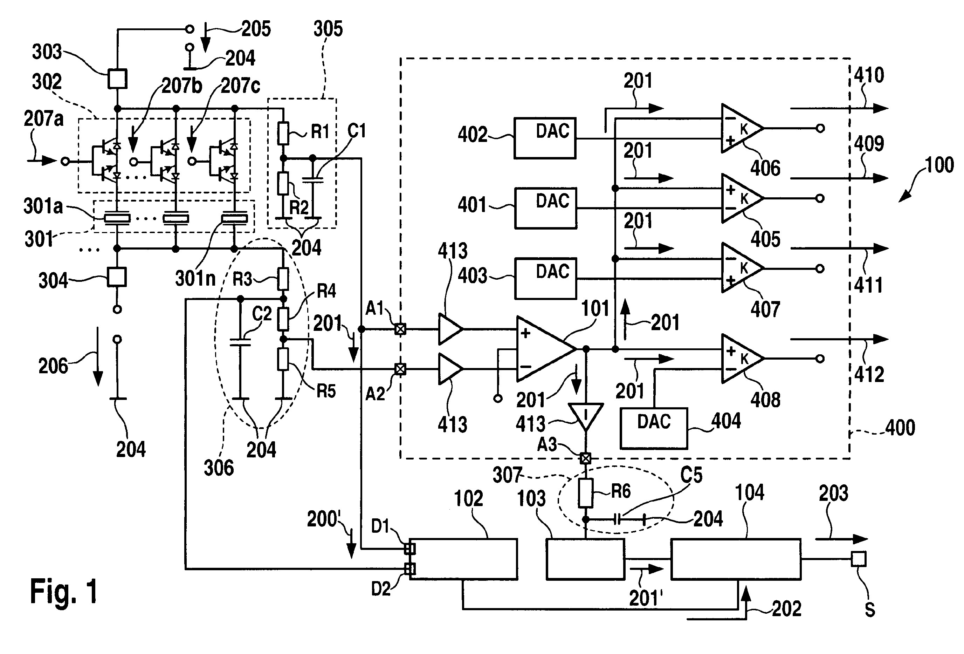

- Fig. 1: ein Blockbild einer Schaltungsanordnung zur Erfassung einer zeitlich veränderlichen Amplitude mindestens einer zu erfassenden elektrischen Potentialdifferenz mit ersten und zweiten Potentialdifferenz-Erfassungseinrichtungen gemäß einem bevorzugten Ausführungsbeispiel der vorliegenden Erfindung.

### BESCHREIBUNG DER AUSFÜHRUNGSBEISPIELE

Fig. 1 zeigt ein Blockbild einer Schaltungsanordnung zur Erfassung einer zeitlich veränderlichen Amplitude mindestens einer zu erfassenden Potentialdifferenz 200 gemäß einem bevorzugten Ausführungsbeispiel der vorliegenden Erfindung. Die in Fig. 1 gezeigte Schaltungsanordnung 100 weist eine Steuereinrichtung 400 zur Bereitstellung von Schaltsteuersignalen 409-412 auf, die in Abhängigkeit von einem Potentialdifferenzsignal erzeugbar sind.

Gemäß dem in Fig. 1 veranschaulichten bevorzugten Ausführungsbeispiel der vorliegenden Erfindung wird die Schaltungsanordnung 100 herangezogen, um eine Differenzspannungsüberwachung an einer Aktoreinheit 301 bereitzustellen. Die Aktoreinheit 301 wird über eine Aktoransteuereinheit 302 angesteuert, wobei die Aktoransteuereinheit 302 extern vorgegebene Aktoransteuersignale 207a, 207b, 207c empfängt. Zum Betrieb der Aktoreinheit 301 werden an einem ersten Versorgungsspannungsanschluss 303 eine erste Aktorversorgungsspannung 205 gegenüber einem Massepotential 204 und an einem zweiten Versorgungsspannungsanschluss 304 eine zweite Aktorversorgungsspannung 206 gegenüber dem Massepotential 204 angelegt.

Die Aktoreinheit 301 besteht aus einzelnen Aktoreinheiten 301a-301n (in der Fig. 1 sind drei einzelne Aktoreinheiten veranschaulicht), welche vorzugsweise als piezoelektrische Stellelemente ausgebildet sind. Derartige piezoelektrische Stellelemente oder Piezo-Aktoren können aus dünnen Piezokristallplatten bestehen, die sich in einem elektrischen Feld ausdehnen. Im Vergleich zu magnetisch angetriebenen Ventilen können piezoelektrische Stellelemente bis zu fünf mal schnellere Schaltgeschwindigkeiten bei einer Kraftstoffeinspritzung in den Brennraum einer Brennkraftmaschine bereitstellen. Hierbei wirken die piezoelektrischen Stellelemente auf eine Ventilnadel eines Einspritzventils, um die Kraftstoffeinspritzung in den Brennraum der Brennkraftmaschine zu bewirken.

Unter Bezugnahme auf Fig. 1 wird nun die Erfassung der an den Aktoreinheiten 301a-301n anliegenden Differenzspannung zwischen den Anschlusseinheiten (nicht gezeigt) einer jeweiligen Aktoreinheit 301a-301n erläutert. Um mit einer piezoelektrischen Aktoreinheit 301a-301n Kraftstoff in den Brennraum der Brennkraftmaschine einbringen zu können, muss die piezoelektrische Aktoreinheit 301a-301n auf eine Spannung von bis zu 200 V gegenüber Masse aufgeladen werden. Ein Laden/Entladen einer derartigen piezoelektrischen Aktoreinheit 301a-301n erfolgt mit einem gepulsten Strom. In jüngerer Zeit sind Aktoreinheiten 301a-301n entwickeln worden, bei welchen ein Pol (eine Anschlusseinheit) der piezoelektrischen Aktoreinheit nicht auf dem Massepotential 204 liegt. Somit kann, wie obenstehend unter Bezugnahme auf den Stand der Technik beschrieben, eine Messung der über der piezoelektrischen Aktoreinheit anliegenden Spannung nicht durch die Messung an dem spannungsführenden Pol (der spannungsführenden Anschlusseinheit) der piezoelektrischen Aktoreinheit 301a-301n erfolgen.

Vielmehr wird erfindungsgemäß eine Messung an beiden Polen (Anschlusseinheiten) der piezoelektrischen Aktoreinheit 301 bereitgestellt. Hierzu sind eine erste Spannungsteilereinheit 305 zur Erfassung der ersten Aktorversorgungsspannung 205 und eine zweite Spannungsteilereinheit 306 zur Messung der zweiten Aktorversorgungsspannung 206 bereitgestellt. Im Folgenden wird die erste Aktorversorgungsspannung 205 auch als eine HS-Spannung (High-Side-Spannung) bezeichnet, während die zweite Aktorversorgungsspannung 206 auch als eine LS-Spannung (Low-Side-Spannung) bezeichnet werden wird.

So sind Aktoreinheiten 301 vorhanden, die nicht nur auf eine positive Spannung (gegenüber Masse), sondern auch auf eine leicht negative Spannung aufgeladen werden können. Hierfür wird eine Anschlusseinheit der Aktoreinheit auf eine LS-Spannung von ca. 45 V gegenüber dem Massepotential 204 gelegt. Wird dann die HS-Spannung (erste Aktorversorgungsspannung 205) auf unterhalb 45 V abgesenkt, so ist die Differenzspannung an den Anschlusseinheiten der Aktoreinheit 301 negativ.

Da die LS-Spannung (zweite Aktorversorgungsspannung) 206 bei einem Betrieb einer Treibereinheit in der Amplitude leicht schwankt, muss zur Bestimmung der über der Aktoreinheit 301 anliegenden Spannung nicht nur die HS-Spannung, d. h. die erste Aktorversorgungsspannung 205, sondern auch die LS-Spannung, d. h. die zweite Aktorversorgungsspannung 206 gemessen werden. Aus den beiden gemessenen Spannungen erfolgt schließlich die Bestimmung einer Potentialdifferenz 200.

Zu diesem Zweck werden die zum Teil mit hohen Spannungsamplituden versehenen ersten und zweiten Aktorversorgungsspannungen 205, 206 den ersten und zweiten Spannungsteilereinheiten 305, 306 zugeführt. Die ersten und zweiten Spannungsteilereinheiten 305, 306 stellen die Kombination einer Spannungsteilung und Filterung bereit. Hierbei erfolgt die Spannungsteilung über eine Serienschaltung zweier Ohm'scher Widerstände, während eine Tiefpassfilterung über eine Serienschaltung eines Ohm'schen Widerstandes und einer Kapazität erfolgt.

Die in Fig. 1 veranschaulichte erste Spannungsteilereinheit 305 weist somit eine Serienschaltung eines Ohm'schen Widerstandes R1 und eine Ohm'schen Widerstandes R2 auf, die zwischen dem ersten Versorgungsspannungsanschluss 303 und Masse 204 verbunden ist. Parallel zu dem Ohm'schen Widerstand R2 ist eine Kapazität C1 angeschlossen. Diese geteilte und gefilterte erste Aktorversorgungsspannung 205 wird einerseits einem ersten Eingangsanschluss A1 der Steuereinrichtung 400 und andererseits einem ersten Eingangsanschluss D1 einer zweiten Potentialdifferenz-Erfassungseinrichtung zugeführt.

Die zweite Spannungsteilereinheit 306 weist eine Serienschaltung dreier Widerstände R3, R4 und R5 auf, die zwischen dem zweiten Versorgungsspannungsanschluss 304 und Masse 204 verbunden sind. Parallel zur der Serienschaltung der Widerstände R4 und R5 ist ein Kondensator C2 (Glättungskapazität) angeschlossen, derart, dass eine Filtereinheit, bestehend aus dem Widerstand R3 und der Kapazität C2 bereitgestellt ist. Die durch die zweite Spannungsteilereinheit 306 geteilte und gefilterte zweite Aktorversorgungsspannung 206 wird einerseits einem zweiten Eingangsanschluss A2 der Steuereinrichtung 400 zugeführt, wobei der Eingangsanschluss A2 mit dem Verbindungspunkt der Widerstände R4 und R5 verbunden ist, und wird andererseits einem zweiten Eingangsanschluss D2 der zweiten Potentialdifferenz-Erfassungseinrichtung 102 zugeführt, wobei der zweite Eingangsanschluss D2 mit dem Verbindungspunkt der Widerstände R3 und R4 verbunden ist.

Auf diese Weise liegt eine Potentialdifferenz 200 zwischen den Eingangsanschlüssen A1 und A2 der Steuereinrichtung 400 an, während eine davon unterschiedene Potentialdifferenz 200' zwischen den Eingangsanschlüssen D1 und D2 der zweiten Potentialdifferenz-Erfassungseinrichtung 102 anliegt. Beide Potentialdifferenzen werden zur Bestimmung der an den Aktoreinheiten 301a-301n anliegenden Differenzspannung herangezogen. Die zweite Potentialdifferenz-Erfassungseinrichtung 102 ist hierbei derart ausgelegt, ein zweites Potentialdifferenzsignal 202 digital zu bestimmen. Das digital bestimmte zweite Potentialdifferenzsignal 202, das aus der digitalen zweiten Potentialdifferenz-Erfassungseinrichtung 102 ausgegeben wird, spiegelt somit einen Digitalwert der Potentialdifferenz 200' wieder. Das zweite Potentialdifferenzsignal 202 wird einer Bearbeitungseinrichtung 104 zugeführt, welche das zweite Potentialdifferenzsignal 202 mit einem ersten Potentialdifferenzsignal 201 verarbeitet, dessen Erzeugung untenstehend im Detail beschrieben ist.

Die Verarbeitungseinrichtung 104 weist einen Steueranschluss S auf, aus welchem ein Steuersignal 203 als Funktion der zugeführten ersten und zweiten Potentialdifferenzsignale 201, 202 ausgegeben wird. Somit ist es, wie untenstehend detaillierter beschrieben, mit der Verarbeitungseinrichtung 104 möglich, das erste Potentialdifferenzsignal 201 und das zweite Potentialdifferenzsignal 202 zur Bereitstellung eines Steuersignals 203 zu verarbeiten, welches eine spezifisch vorgegebene Amplitudenauflösung und/oder eine spezifisch vorgegebene Zeitauflösung aufweist.

Die Potentialdifferenz 200, die an den Eingangsanschlüssen A1 und A2 der Steuereinrichtung 400 anliegt, wird auf eine analoge Weise in einer ersten Potentialdifferenz-Erfassungseinrichtung 101 gemessen. Zu diesem Zweck sind die Eingänge eines Differenzverstärkers (+, -) über jeweilige Koppeleinheiten 413 mit den Eingängen A1 und A2 der Steuereinrichtung 400 verbunden. Das Ausgangssignal, das aus der ersten Potentialdifferenz-Erfassungseinrichtung 101 ausgegeben wird, stellt ein analoges erstes Potentialdifferenzsignal 201 dar, welches über eine weitere Koppeleinheit 413 über einen Ausgangsanschluss A3 aus der Steuereinrichtung 400 ausgegeben wird. Der Ausgangs A3 der Steuereinrichtung 400 ist über einen Widerstand R6 mit einem Analog-Digital-Konverter 103 verbunden.

Dieser Analog-Digital-Konverter 103, der der ersten Potentialdifferenz-Erfassungseinrichtung 101 nachgeschaltet ist, wandelt das aus der ersten Potentialdifferenz-Erfassungseinrichtung 101 ausgegebene erste Potentialdifferenzsignal 201 mit einer hohen Geschwindigkeit in ein digitales erstes Potentialdifferenzsignal 201' um. Dieses digital konvertierte erste Potentialdifferenzsignal 201' wird ebenfalls der Verarbeitungseinrichtung 104 zugeführt. Zwischen einem Eingangsanschluss des Analog-Digital-Konverters 103 und Masse 204 ist ein Kondensator C5 angeordnet, welcher zusammen mit dem Widertand R6 eine Filtereinheit 307 (Tiefpassfilter) ausbildet. Die Verarbeitungseinrichtung 104 führt hierbei eine Verarbeitung des ersten Potentialdifferenzsignals 201' und zweiten Potentialdifferenzsignals 202 derart durch, dass ein Steuersignal 203 an einem Ausgangsanschluss S der Verarbeitungseinrichtung 104 bereitgestellt wird, welches eine hohe Amplitudenauflösung und/oder eine hohe Zeitauflösung aufweist.

Im Folgenden werden diejenigen Komponenten der Steuereinrichtung 400 beschrieben werden, die zur Erzeugung von Abschaltsteuersignalen herangezogen werden. Derartige Abschaltsteuersignale dienen dazu, die gesamte Schaltungsanordnung zu deaktivieren, wenn die gemessenen Spannungen bzw. Differenzspannungen außerhalb eines vorbestimmten Bereichs liegen.

Das aus der ersten Potentialdifferenz-Erfassungseinrichtung 101 ausgegebene erste Potentialdifferenzsignal 201 wird gleichzeitig vier Komparatoreinheiten, d. h. einer ersten Komparatoreinheit 405, einer zweiten Komparatoreinheit 406, einer dritten Komparatoreinheit 407 und einer vierten Komparatoreinheit 408 zugeführt. Ferner sind in der Steuereinrichtung 400 vier Referenzspannungseinstelleinheiten bereitgestellt, d. h. eine erste Referenzspannungseinstelleinheit 401, eine zweite Referenzspannungseinstelleinheit 402, eine dritte Referenzspannungseinstelleinheit 403 und eine vierte Referenzspannungseinstelleinheit 404. Diese Referenzspannungseinstelleinheiten dienen der Einstellung spezifisch vorgebbarer Referenzspannungen, um das aus der ersten Potentialdifferenz-Erfassungseinrichtung 101 ausgegebene erste Potentialdifferenzsignal 201 hinsichtlich seiner Spannungswerte zu überwachen. Die erste Referenzspannungseinstelleinheit 401 gibt ein Schwellenspannungssignal aus, das einer maximalen Spannung an einem positiven Eingang (HS-Spannungssignal, siehe obenstehend) entspricht. Überschreitet das erste Potentialdifferenzsignal 201 diese maximale Spannung, die typischerweise in einem Bereich zwischen 150 bis 300 V liegt, so wird ein erstes Abschaltsteuersignal 409 ausgegeben. Vorzugsweise ist die erste Referenzspannungseinstelleinheit 401 als ein Digital-Analog-Konverter mit einer Auflösung von 4 Bit bereitgestellt, derart, dass eine analoge Spannung in einem Bereich von 150 bis 300 V mit einer Auflösung von 10 V eingestellt werden kann.

Auf ähnliche Weise wie die erste Referenzspannungseinstelleinheit 401 arbeitet die zweite Referenzspannungseinstelleinheit 402, die eine untere Schwellenspannung definiert, die der LS-Spannungssignalanschluss der Aktoreinheit 301 nicht unterschreiten darf. Eine derartige Schwelle wird in einem Bereich von - 100 bis 50 V bei einer Auflösung von 10 V bereitgestellt, wobei das Schwellensignal der zweiten Komparatoreinheit 406 zugeführt wird. Falls eine derartige Schwelle überschritten ist, wird ein zweites Abschaltsteuersignal 410 ausgegeben.

Die dritte Referenzspannungseinstelleinheit 403 dient dazu, eine Klemmenspannung festzulegen. Zu diesem Zweck wird das erste Potentialdifferenzsignal 201 mit einer aus der dritten Referenzspannungseinstelleinheit 403 ausgegebenen Referenzklemmenspannung verglichen. Falls eine derartige Schwelle überschritten wird, wird ein drittes Abschaltsteuersignal 411 aus der dritten Komparatoreinheit 407 ausgegeben.

Die vierte Referenzspannungseinstelleinheit 404 ist ebenfalls, wie die vorstehenden Referenzspannungseinstelleinheiten 401-403, als ein Digital-Analog-Konverter ausgebildet, der im Unterschied zu den voranstehend beschriebenen Digital-Analog-Konvertern 401-403 eine Auflösung von 8 Bit aufweist. Hierdurch wird ein Schwellensignal entsprechend - 40 bis 215 V bei einer Auflösung von 1 V ausgegeben, wobei dieses Signal der vierten Komparatoreinheit 408 zugeführt wird. In der vierten Komparatoreinheit 408 wird dieses Signal mit dem ersten Potentialdifferenzsignal 201 verglichen, um dann, wenn das erste Potentialdifferenzsignal 201 außerhalb eines vorgebbaren Bereichs liegt, dann ein viertes Abschaltsteuersignal 412 aus der vierten Komparatoreinheit 408 ausgegeben wird.

Die mittels der ersten und zweiten Potentialdifferenz-Erfassungseinrichtung 101 bzw. 102 gemessenen ersten und zweiten Potentialdifferenzsignale 201 bzw. 202 werden auf Schaltungskomponenten zur Verfügung gestellt, die eigenständig nicht in der Lage sind, eine Differenzspannung zu erfassen.

Vorzugsweise erfolgt die Messung der Differenzspannung über die beiden Spannungsteilereinheiten 305 und 306, die in einer bevorzugten Ausführungsform der vorliegenden Erfindung das gleiche Teilerverhältnis aufweisen. Vorzugsweise wird das gleiche Spannungsteilerverhältnis verwendet, wenn die Differenzspannung über die erste Potentialdifferenz-Erfassungseinrichtung 101 bestimmt werden soll, während bei der zweiten Potentialdifferenz-Erfassungseinrichtung 102 auch unterschiedliche Teilerverhältnisse in den ersten und zweiten Spannungsteilereinheiten 305 bzw. 306 bereitgestellt werden können. Insbesondere ist es ein Vorteil der vorliegenden Ausführungsform, dass die Differenzspannung auf unterschiedliche Weisen ermittelt wird, derart, dass die jeweils genaueste Messung herangezogen werden kann. Insbesondere wird mit der ersten Potentialdifferenz-Erfassungseinrichtung 101 eine höhere Zeitauflösung als mit der zweiten Potentialdifferenz-Erfassungseinrichtung 102 erreicht, so dass dann, wenn eine höhere Zeitauflösung zur Messung der Potentialdifferenz erforderlich ist, die erste Potentialdifferenz-Erfassungseinrichtung 101 herangezogen werden kann.

Andererseits weist die zweite Potentialdifferenz-Erfassungseinrichtung 102 eine höhere Amplitudenauflösung als die erste Potentialdifferenz-Erfassungseinrichtung 101 auf. Insbesondere in Fällen, in denen es auf eine besonders genaue Bestimmung der Amplitude der Differenzspannung ankommt, wird somit die zweite Potentialdifferenz-Erfassungseinrichtung 102 zur Bestimmung der Differenzspannung an der Aktoreinheit 30 herangezogen.

Durch die erfindungsgemäße Schaltungsanordnung ist es somit möglich, eine zu erfassende elektrische Potentialdifferenz 200, die an Aktoreinheiten 301a-301n anliegt, mit einer hohen Präzision sowohl hinsichtlich der Zeitauflösung als auch hinsichtlich der Amplitudenauflösung zu erfassen. Durch ein gleichzeitiges Erfassen einer derartigen Differenzspannung mit unterschiedlichen Baugruppen kann jeweils diejenige Messung herangezogen werden, die die größte Präzision aufweist. Andere Messungen können nach der Messung mit größter Präzision abgeglichen werden. Die in der obenstehenden Beschreibung erläuterte Differenzspannungsmessung kann in Steuergeräten für Piezo-Common-Rail-Dieselsysteme mit Injektor mit direkter Nadelsteuerung insbesondere vorteilhaft eingesetzt werden.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Auch ist die Erfindung nicht auf die genannten Anwendungsmöglichkeiten beschränkt.

## Patentansprüche

1. Schaltungsanordnung (100) zur Erfassung einer zeitlich veränderlichen Amplitude mindestens einer zu erfassenden elektrischen Potentialdifferenz (200), mit:
a) einer ersten Potentialdifferenz-Erfassungseinrichtung (101) zur Erfassung der mindestens einen elektrischen Potentialdifferenz (200) und zur Ausgabe eines ersten Potentialdifferenzsignals (201); und
b) einer zweiten Potentialdifferenz-Erfassungseinrichtung (102) zur Erfassung der mindestens einen elektrischen Potentialdifferenz (200) und zur Ausgabe eines zweiten Potentialdifferenzsignals (202),
**dadurch gekennzeichnet,**
c) **dass** die erste Potentialdifferenz-Erfassungseinrichtung (101) eine höhere Zeitauflösung als die zweite Potentialdifferenz-Erfassungseinrichtung (102) aufweist; und
d) **dass** die zweite Potentialdifferenz-Erfassungseinrichtung (102) eine höhere Amplitudenauflösung als die erste Potentialdifferenz-Erfassungseinrichtung (101) aufweist.

2. Schaltungsanordnung (100) nach Anspruch 1,
**dadurch gekennzeichnet,**
**dass** die erste Potentialdifferenz-Erfassungseinrichtung (101) ausgelegt ist, das erste Potentialdifferenzsignal (201) analog zu bestimmen.

3. Schaltungsanordnung (100) nach Anspruch 1 oder 2,
**dadurch gekennzeichnet,**
**dass** die zweite Potentialdifferenz-Erfassungseinrichtung (102) ausgelegt ist, das zweite Potentialdifferenzsignal (202) digital zu bestimmen.

4. Schaltungsanordnung (100) nach Anspruch 2,
**dadurch gekennzeichnet,**
**dass** der ersten Potentialdifferenz-Erfassungseinrichtung (101) ein Analog-Digitalkonverter (103) nachgeschaltet ist.

5. Schaltungsanordnung (100) nach Anspruch 1,
**gekennzeichnet**
**durch** eine Verarbeitungseinrichtung (104) zur Verarbeitung des ersten Potentialdifferenzsignals (201) und des zweiten Potentialdifferenzsignals (202) zur Bereitstellung eines Steuersignals (203), welches eine hohe Amplitudenauflösung und/oder eine hohe Zeitauflösung aufweist.

6. Verfahren zum Erfassen einer zeitlich veränderlichen Amplitude mindestens einer zu erfassenden elektrischen Potentialdifferenz (200), mit den Schritten:
a) Erfassen der mindestens einen elektrischen Potentialdifferenz (200) mittels einer ersten Potentialdifferenz-Erfassungseinrichtung (101);
b) Ausgeben eines ersten Potentialdifferenzsignals (201) aus der ersten Potentialdifferenz-Erfassungseinrichtung (101);
c) Erfassen der mindestens einen elektrischen Potentialdifferenz (200) mittels einer zweiten Potentialdifferenz-Erfassungseinrichtung (102); und
d) Ausgeben eines zweiten Potentialdifferenzsignals (202) aus der zweiten Potentialdifferenz-Erfassungseinrichtung (102),
**dadurch gekennzeichnet,**
e) **dass** die erste Potentialdifferenz-Erfassungseinrichtung (101) die elektrische Potentialdifferenz (200) mit einer höheren Zeitauflösung erfasst als die zweite Potentialdifferenz-Erfassungseinrichtung (102); und
f) **dass** die zweite Potentialdifferenz-Erfassungseinrichtung (102) die elektrische Potentialdifferenz (200) mit einer höheren Amplitudenauflösung erfasst als die erste Potentialdifferenz-Erfassungseinrichtung (101).

7. Verfahren nach Anspruch 6,
**dadurch gekennzeichnet,**
**dass** das erste Potentialdifferenzsignal (201) mit der ersten Potentialdifferenz-Erfassungseinrichtung (101) analog bestimmt wird.

8. Verfahren nach Anspruch 6 oder 7,
**dadurch gekennzeichnet,**
**dass** das zweite Potentialdifferenzsignal (202) mit der zweiten Potentialdifferenz-Erfassungseinrichtung (102) digital bestimmt wird.

9. Verfahren nach Anspruch 8,
**dadurch gekennzeichnet,**
**dass** das erste Potentialdifferenzsignal (201) und das zweite Potentialdifferenzsignal (202) mittels einer Verarbeitungseinrichtung (104) zu einem Steuersignals (203) verarbeitet werden, welches eine hohe Amplitudenauflösung und/oder eine hohe Zeitauflösung aufweist.

## Claims

1. Circuit arrangement (100) for detecting a temporally variable amplitude of at least one electrical potential difference (200) to be detected, said circuit arrangement having:
a) a first potential difference detection device (101) for detecting the at least one electrical potential difference (200) and for outputting a first potential difference signal (201); and
b) a second potential difference detection device (102) for detecting the at least one electrical potential difference (200) and for outputting a second potential difference signal (202),
**characterized**
c) **in that** the first potential difference detection device (101) has a higher time resolution than the second potential difference detection device (102); and
d) **in that** the second potential difference detection device (102) has a higher amplitude resolution than the first potential difference detection device (101).

2. Circuit arrangement (100) according to Claim 1,
**characterized in that**
the first potential difference detection device (101) is designed to determine the first potential difference signal (201) in an analogue manner.

3. Circuit arrangement (100) according to Claim 1 or 2,
**characterized in that**
the second potential difference detection device (102) is designed to determine the second potential difference signal (202) in a digital manner.

4. Circuit arrangement (100) according to Claim 2,
**characterized in that**
an analogue/digital converter (103) is connected downstream of the first potential difference detection device (101).

5. Circuit arrangement (100) according to Claim 1,
**characterized**
**by** a processing device (104) for processing the first potential difference signal (201) and the second potential difference signal (202) in order to provide a control signal (203) which has a high amplitude resolution and/or a high time resolution.

6. Method for detecting a temporally variable amplitude of at least one electrical potential difference (200) to be detected, said method having the steps of:
a) detecting the at least one electrical potential difference (200) using a first potential difference detection device (101);
b) outputting a first potential difference signal (201) from the first potential difference detection device (101);
c) detecting the at least one electrical potential difference (200) using a second potential difference detection device (102); and
d) outputting a second potential difference signal (202) from the second potential difference detection device (102),
**characterized**
e) **in that** the first potential difference detection device (101) detects the electrical potential difference (200) with a higher time resolution than the second potential difference detection device (102); and
f) **in that** the second potential difference detection device (102) detects the electrical potential difference (200) with a higher amplitude resolution than the first potential difference detection device (101).

7. Method according to Claim 6,
**characterized in that**
the first potential difference signal (201) is determined in an analogue manner using the first potential difference detection device (101).

8. Method according to Claim 6 or 7,
**characterized in that**
the second potential difference signal (202) is determined in a digital manner using the second potential difference detection device (102).

9. Method according to Claim 8,
**characterized in that**
the first potential difference signal (201) and
the second potential difference signal (202) are processed using a processing device (104) to form a control signal (203) which has a high amplitude resolution and/or a high time resolution.

## Revendications

1. Ensemble de circuit (100) destiné à détecter une amplitude variable dans le temps d'au moins une différence de potentiel électrique (200) à détecter, et présentant :
a) un premier dispositif (101) de détection de différence de potentiel qui détecte la ou les différences de potentiel électrique (200) et qui délivre un premier signal (201) de différence de potentiel et
b) un deuxième dispositif (102) de détection de différence de potentiel qui détecte la ou les différences de potentiel électrique (200) et délivre un deuxième signal (202) de différence de potentiel,
**caractérisé en ce que**
c) le premier dispositif (101) de détection de différence de potentiel a une résolution temporelle plus élevée que le deuxième dispositif (102) de détection de différence de potentiel et
d) **en ce que** le deuxième dispositif (102) de détection de différence de potentiel présente une résolution en amplitude plus élevée que le premier dispositif (101) de détection de différence de potentiel.

2. Ensemble de circuit (100) selon la revendication 1, **caractérisé en ce que** le premier dispositif (101) de détection de différence de potentiel est conçu pour déterminer analogiquement le premier signal (201) de différence de potentiel.

3. Ensemble de circuit (100) selon les revendications 1 ou 2, **caractérisé en ce que** le deuxième dispositif (102) de détection de différence de potentiel est conçu pour déterminer numériquement le deuxième signal (202) de différence de potentiel.

4. Ensemble de circuit (100) selon la revendication 2, **caractérisé en ce qu'**un convertisseur analogique-numérique (103) est raccordé en aval du premier dispositif (101) de détection de différence de potentiel.

5. Ensemble de circuit (100) selon la revendication 1, **caractérisé par** un dispositif de traitement (104) qui traite le premier signal (201) de différence de potentiel et le deuxième signal (202) de différence de potentiel pour préparer un signal de commande (203) qui présente une haute résolution en amplitude et/ou une haute résolution temporelle.

6. Procédé de détermination d'une amplitude variable dans le temps d'au moins une différence de potentiel électrique (200) à détecter, et présentant les étapes qui consistent à :
a) détecter la ou les premières différences de potentiel électrique (200) au moyen d'un premier dispositif (101) de détection de différence de potentiel,
b) faire délivrer un premier signal (201) de différence de potentiel par le premier dispositif (101) de détection de différence de potentiel,
c) détecter la ou les différences de potentiel électrique (200) au moyen d'un deuxième dispositif (102) de détection de différence de potentiel et
d) faire délivrer un deuxième signal (202) de différence de potentiel par le deuxième dispositif (102) de détection de différence de potentiel,
**caractérisé en ce que**
e) le premier dispositif (101) de détection de différence de potentiel détecte la différence de potentiel électrique (200) avec une plus haute résolution temporelle que le deuxième dispositif (102) de détection de différence de potentiel et
f) **en ce que** le deuxième dispositif (102) de détection de différence de potentiel détecte la différence de potentiel électrique (200) avec une résolution en amplitude plus élevée que le premier dispositif (101) de détection de différence de potentiel.

7. Procédé selon la revendication 6, **caractérisé en ce que** le premier signal (201) de différence de potentiel est déterminé analogiquement par le premier dispositif (101) de détection de différence de potentiel.

8. Procédé selon les revendications 6 ou 7, **caractérisé en ce que** le deuxième signal (202) de différence de potentiel est déterminé numériquement par le deuxième dispositif (102) de détection de différence de potentiel.

9. Procédé selon la revendication 8, **caractérisé en ce que** le premier signal (201) de différence de potentiel et le deuxième signal (202) de différence de potentiel sont transformés au moyen d'un dispositif de traitement (104) en un signal de commande (203) qui présente une haute résolution en amplitude et/ou une haute résolution temporelle.
